# EUROPEAN PATENT APPLICATION

(11) **EP 0 628 991 A1**
(43) Date of publication of application: **14.12.1994**
(21) Application number: 94104513.0
(22) Date of filing: 22.03.1994
(51) Int. Cl.: H01L 21/22, H01L 21/263, H01L 29/32, H01L 29/74

(54) **Semiconductor device having reduced carrier lifetime and method of manufacturing the same**

(30) Priority: 08.06.1993 JP 137386/93
(71) Applicant: KABUSHIKI KAISHA TOSHIBA, Kawasaki-shi, Kanagawa-ken 210 (JP)
(72) Inventor: Tsunoda, Yoshiaki, 1-1 Shibaura 1-chome, Minato-ku, Tokyo (JP); Kanaya, Masatoshi, 1-1 Shibaura 1-chome, Minato-ku, Tokyo (JP); Yoshida, Takeomi, 1-1 Shibaura 1-chome, Minato-ku, Tokyo (JP); Nimura, Tomoki, 1-1 Shibaura 1-chome, Minato-ku, Tokyo (JP)
(74) Representative: Lehn, Werner, Dipl.-Ing.

(57) **Abstract**

A semiconductor device comprises a semiconductor body (6) of multi-layer structure of two or more semiconductor layers (1-4) with alternately changing conductivity types, wherein a concentration of a heavy metal such as gold or platinum for controlling a lifetime of a carrier is lower in a peripheral or surrounding region (5) of a cathode-emitter layer (4) than in the cathode-emitter layer (4) and in a region of another layer (1-3) just below the cathode-emitter layer (4). The seggregation of gold or platinum atoms (for controlling the lifetime) with heavy metal atoms (such as Fe, Cn, Ni) is more likely in a peripheral or surrounding region (5) due to the gettering effect of phosphorus atoms used for doping the n-type emitter (4). As the amount of gold or platinum is small in this peripheral or surrounding region (5), the breakdown voltage characteristics of the semiconductor device are enhanced, and degradation in turn-off characteristics is prevented.

## Description

The present invention relations to a semiconductor device having a semiconductor body of multi-layer structure made of two or more semiconductor layers with the conductivity types of the semiconductor layers being changed alternately, and a method of manufacturing the same, and more particularly to a semiconductor device used as a power device of high-breakdown voltage and large capacity such as a rectifier and a method of manufacturing the same.

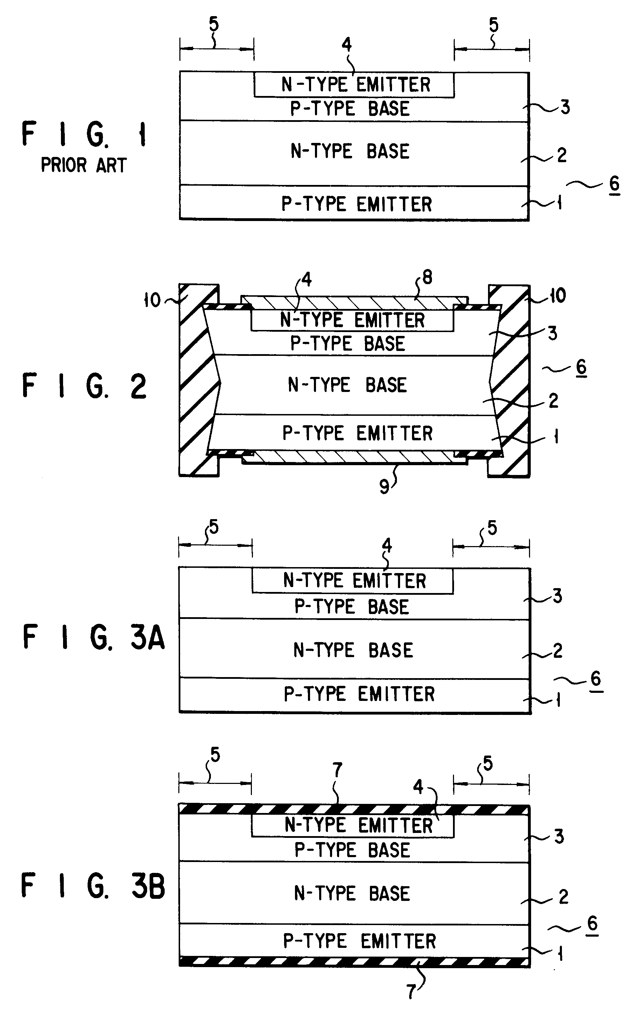

FIG. 1 shows a conventional semiconductor device (thyristor) of this type. Reference numeral 1 denotes a P-type emitter layer, 2 an N-type base layer, and 3 a P-type base layer. An N-type emitter layer (cathode emitter) 4 is provided in the P-type base layer 3 by selective diffusion of impurity. Numeral 5 denotes a peripheral or surrounding region of the cathode emitter 4, which is seen when a semiconductor device body 6 is viewed from above (i.e. in plan view).

In general, in a thyristor used at a frequency not greater than that of a commercial power, in order to improve turn-off characteristics, the lifetime of carriers needs to be decreased by means of diffusion of a heavy metal such as gold or platinum or radiation of electron beams. In an electric power device, gold used as lifetime killer is superior in terms of relationship between on-voltage and turn-off characteristics. Thus, the diffusion of gold is adopted predominantly, but it may be combined with radiation of electron beams.

In a gold diffusion process, gold is plated or deposited on a semiconductor wafer, and then the gold is diffused on the entire surface at temperatures of 750 to 850°C. Thereby, the lifetime is decreased to a predetermined value. However, gold tends to segregate with such a heavy metal as iron in silicon, and the segregation may results in degradation in breakdown voltage of the semiconductor device. The heavy metal such as iron tends to be gettered by phosphorus within the cathode emitter layer 4. Thus, the amount of the heavy metal is small in the cathode emitter layer 4 and in regions of the other layers just below the cathode emitter layer 4, and it tends to be greater in the surrounding region 5 than in the regions under the cathode emitter layer 4.

On the other hand, in order to increase a main breakdown voltage, a beveled portion is provided at a peripheral wall portion of the surrounding region 5, although not shown, and is protected by a passivation film. However, a degradation in breakdown voltage may occur easier in the bevel surface than in a bulk portion. Accordingly, if segregated gold and the heavy metal are present in the beveled portion, a further degradation in breakdown voltage may occur, resulting in a lower yield of semiconductor devices.

The present invention has been made in consideration of the above problems, and its object is to provide a semiconductor device wherein a yield with respect to breakdown voltage can be increased while good turn-off characteristics can be maintained. This invention is very effectively applicable to thyristors.

In order to achieve the object, there is provided a semiconductor device comprising a semiconductor body of multi-layer structure made of two or more semiconductor layers with alternately changing conductivity types, wherein a concentration of a heavy metal for controlling a lifetime of a carrier is lower in a peripheral or surrounding region of a cathode-emitter layer than in the cathode-emitter layer and in a region of another layer just below the cathode-emitter layer. In addition, in this invention, there is provided a method of manufacturing a semiconductor device comprising a semiconductor body of multi-layer structure made of two or more semiconductor layers with alternately changing conductivity types, wherein a lifetime controlling heavy metal is diffused in the semiconductor body, with an outside region of a cathode-emitter layer of the semiconductor body covered with a mask, and lifetime control beam is radiated on the outside region of the cathode-emitter layer.

Specifically, in the present invention, the possibility of presence of a lifetime control heavy metal in the outside region of the cathode-emitter layer is reduced to a minimum. Therefore, segregation of the lifetime control heavy metal with a heavy metal, such as iron, present in silicon can be prevented in the outside region of the cathode-emitter layer, and good breakdown voltage characteristics can be obtained. Moreover, electron beams, etc. are radiated onto the outside region of the cathode-emitter layer to make the lifetime in this outside region lower than that in the cathode-emitter region. Thereby, good turn-off characteristics can be maintained.

This invention can be more fully understood from the following detailed description when taken in conjunction with the accompanying drawings, in which:
FIG. 1 is a cross-sectional view of a conventional thyristor;
FIG. 2 is a cross-sectional view of a thyristor according to an embodiment of the present invention; and
FIGS. 3A to 3E are cross-sectional views illustrating the steps of manufacturing the thyristor shown in FIG. 2.

An embodiment of the present invention will now be described with reference to the accompanying drawings. FIG. 2 is a cross-sectional view showing the structure of the embodiment. The structural elements already appearing in FIG. 1 are denoted by like reference numerals.

In FIG. 2, reference numeral 1 denotes a P-type emitter layer, 2 an N-type base layer, and 3 a P-type base layer. An N-type emitter layer (cathode emitter layer) 4 is provided in the P-type base layer 3 by selective diffusion of impurity. Numeral 5 denotes a peripheral or surrounding region of the cathode emitter 4, which is seen when a semiconductor device body 6 is viewed from above (i.e. in plan view).

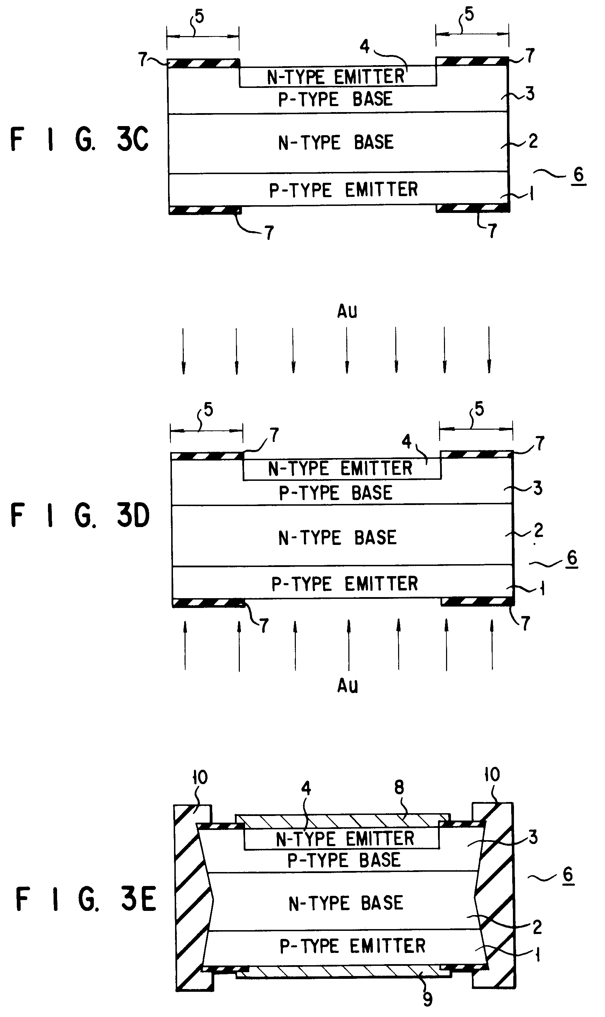

With respect to a process of manufacturing the above semiconductor device, the four impurity-diffused layers 1, 2, 3 and 4 of a P-N four-layer structure, which constitute the semiconductor device (thyristor) body 6 are provided by a conventional method, as shown in FIG. 3A. It is desirable that the N-type emitter layer 4 be formed, in particular, by diffusion of phosphorus. Then, as shown in FIG. 3B, both major surfaces of the four-layer structure are oxidized to form oxide films 7. Thereafter, the oxide films 7 are subjected to a photolithography treatment, and, as shown in FIG. 3C, the oxide films are left only on the exposed regions of the P-type base layer 3, i.e. on the regions 5, and on those regions of the P-type emitter layer 1, which correspond to the regions 5. Then, gold is diffused through both major surfaces to lower the lifetime to a predetermined value. Normally, the gold diffusion is performed from both or one of the major surfaces, with the oxide films 7 used as masks, by means of gold plating or gold deposition at temperatures of 750 to 850°C. In this case, gold is diffused towards the inner base layers 2 and 3 through the non-masked regions, i.e. the major surface region of the cathode-emitter layer 4 and the corresponding region of the P-type emitter layer 1. On the other hand, little gold is diffused from the major surfaces of the surrounding regions 5, since the oxide films 7 formed on the regions 5 serve as masks. Thus, gold is diffused only in the lateral direction from the non-masked regions. Accordingly, the gold concentration in the region of each layer, which correspond to the surrounding region of the cathode emitter layer 4, is lower than that in the cathode-emitter layer 4 and the regions just below the cathode-emitter layer 4. Then, as is shown in FIG. 3E, Aℓ electrodes 8 and 9 are formed by a conventional method on the N-type emitter layer 4 and P-type emitter layer 1, and a beveled portion is formed by a conventional method on the outer peripheral wall of the semiconductor body 6. The beveled portion is coated with a passivation film 10 by a conventional method.

As regards heavy metals such as Fe, Cu, Ni, etc. which may segregate with gold and decrease the breakdown voltage, it is effective to getter those heavy metals by phosphorus. Accordingly, when the cathode-emitter layer 4 is formed by diffusion of phosphorus, the heavy metals which segregate with gold within the cathode-emitter layer 4 are guttered by phosphorus. Thus, the amount of those heavy metals in the cathode-emitter layer 4 and the regions under the cathode-emitter layer 4 is less than that in the surrounding regions. Since therefore the degree of segregation of gold and the heavy metals in the cathode-emitter layer and the regions just below the cathode-emitter layer is lower than that in the surrounding regions, the degree of decrease in breakdown voltage in the cathode-emitter layer and the regions just below the cathode-emitter layer can be reduced.

On the other hand, in the surrounding region 5, since little phosphorus is diffused, little phosphorus gettering is performed. Thus, the amount of heavy metals such as Fe in the surrounding region 5 is greater than that in the cathode-emitter layer and the regions just below the cathode-emitter layer 4. However, since the gold concentration of the surrounding region 5 is very low because of lateral diffusion from the cathode-emitter layer 4, the degree of segregation of gold and heavy metals in the surrounding region 5 is very low and the degree of decrease in breakdown voltage in the surrounding region 5 can be reduced. Therefore, the degree of decrease in breakdown voltage due to gold diffusion in the entire device can be reduced.

In the above embodiment of the entire device, little gold is diffused in the surrounding region 5 of the cathode-emitter layer 4 because of the presence of the masks 7, and accordingly the lifetime in the region 5 is long. As a result, the turn-off characteristics may be adversely affected. To solve this problem, electron beams, for example, may be radiated on the surrounding region alone, thereby decreasing the lifetime in the surrounding region 5. Accordingly, excellent thyristor characteristics can be obtained with no adverse affect on turn-on characteristics.

The present invention is not limited to the above embodiment, and various modifications can be made. For example, the lifetime control of the cathode-emitter can be effected not only by gold diffusion but also by platinum diffusion. The present invention is applicable not only to thyristors but also to a GTO (gate turn-on thyristor), a diode, a transistor, etc. In the present invention, the lifetime control of the surrounding region of the cathode-emitter may be effected not only by electron beam radiation but also by proton radiation. Furthermore, nitride films as well as oxide films may be used as masks for diffusion of heavy metals such as gold. In this invention, the semiconductor device may be of an alloy type wherein silicon and a heat buffer plate are formed of an alloy, or of an alloy-free type wherein silicon is free.

As has been described above, according to the present invention, since no segregation phenomenon occurs in the surrounding region of the semiconductor device body, good breakdown voltage characteristics can be obtained. Moreover, since the lifetime in the surrounding region of the cathode-emitter is made lower than that in the cathode-emitter, the turn-off time characteristics of the device are not adversely affected.

## Claims

1. A semiconductor device comprising a semiconductor body (6) of multi-layer structure made of two or more semiconductor layers (1-4) with alternately changing conductivity types, wherein a concentration of a heavy metal for controlling a lifetime of a carrier is lower in a peripheral region (5) of a cathode-emitter layer (4) than in the cathode-emitter layer (4) and in a region of another layer (1-3) just below the cathode-emitter layer (4).

2. The semiconductor device according to claim 1, characterized in that the lifetime in the peripheral region (5) of the cathode-emitter layer (4) is less than that in the cathode-emitter layer (4).

3. The semiconductor device according to claim 1, characterized in that an outer peripheral portion (5) of said semiconductor body (6) is provided with a beveled portion for increasing a breakdown voltage.

4. A method of manufacturing a semiconductor device comprising a semiconductor body (6) of multi-layer structure made of two or more semiconductor layers (1-4) with alternately changing conductivity types, wherein a lifetime controlling heavy metal is diffused in said semiconductor body (6), with an outside region (5) of a cathode-emitter layer (4) of said semiconductor body (6) covered with a mask.

5. The method according to claim 4, characterized in that lifetime control beam radiation is effected on said outside region (5) of said cathode-emitter layer (4).

6. The method according to claim 5, characterized in that said lifetime control beam radiation is one of electron beam radiation and proton radiation.

7. The method according to claim 4 or 5, characterized in that a side wall of said outside region (5) of the cathode-emitter layer (4) is beveled.
